# EUROPEAN PATENT SPECIFICATION

(11) **EP 3 471 269 B1**
(45) Date of publication and mention of the grant of the patent: **13.12.2023**
(21) Application number: 17196264.0
(22) Date of filing: 13.10.2017
(51) Int. Cl.: H03K 17/0812, H03K 17/0814, H03K 17/10

(54) **SWITCH CIRCUIT FOR CONNECTING AND DISCONNECTING AN ELECTRICAL COMPONENT BETWEEN A HIGH VOLTAGE POTENTIAL AND A LOW VOLTAGE POTENTIAL**
SCHALTKREISLAUF ZUR VERBINDUNG UND TRENNUNG EINER ELEKTRISCHEN KOMPONENTE ZWISCHEN EINEM HOCHSPANNUNGSPOTENZIAL UND EINEM NIEDERSPANNUNGSPOTENZIAL
CIRCUIT DE COMMUTATION POUR CONNECTER ET DÉCONNECTER UN COMPOSANT ÉLECTRIQUE ENTRE UN POTENTIEL HAUTE TENSION ET UN POTENTIEL BASSE TENSION

(43) Date of publication of application: 17.04.2019
(73) Proprietor: Samsung SDI Co., Ltd., Yongin-si, Gyeonggi-do 17084 (KR)
(72) Inventor: Fritz, Jürgen, 8010 Graz (AT); Korherr, Thomas, 8230 Hartberg (AT)
(74) Representative: Gulde & Partner

(56) References cited:
- EP-A2- 0 453 376
- WO-A1-98/12817

## Description

### Field of the Invention

The present invention relates to a switch circuit for connecting and disconnecting an electrical component between a high voltage potential and a low voltage potential. The switch circuit comprises a control terminal, a first connection terminal for the connection to a high voltage, HV, potential and a second connection terminal for the connection to a low voltage, LV, potential. The switch circuit further comprises a first field-effect transistor, first FET, which comprises a gate-terminal, a drain-terminal electrically connected to the first connection terminal, and a source-terminal electrically connected to the second connection terminal.

### Technological Background

So called high voltage, HV, systems - for example high voltage board nets in motorized vehicles - usually require at least one device that allows to connect and to disconnect an impedance, e.g. a resistor, between a high voltage potential and a low voltage, LV, potential.

Within a HV system, the aforementioned high voltage potential exemplarily can be provided by the positive or the negative pole of an electric power source, e.g. of a rechargeable or a secondary battery. The aforementioned low voltage or ground potential can exemplarily be provided by the electric chassis of a motorized vehicle that may be arranged close to the rechargeable or the secondary battery. Oftentimes, HV systems are isolated from the low voltage potential, e.g. from the ground potential via an isolation resistance. Due to safety issues, such an isolation resistance needs to be monitored, which needs to take into account many different standards and regulations. The aforementioned isolation monitoring e.g. is the subject of the so called ECE R100, which also among others requires that specific components can be reliably disconnected from a high voltage system so that a high voltage measurement can be performed.

However, in order to provide for the aforementioned connecting and disconnecting function, oftentimes expensive integrated switches come to use, for example so called PhotoMOS relays. Furthermore, many of these switches require additional and costly protection circuits.

Moreover, the switches of the state of the art can only disadvantageously be stacked, meaning that different difficulties arise when the switches are connected in series. Further, most of the switches of the state of the art have a defined minimum distance of clearance and creepage allowed which has to be met in order to fulfill the isolation requirements of a complete system.

EP 0453376 A2 relates to a medium-voltage static switch comprising a plurality of voltage-controllable power semiconductors, each comprising a gate, a source and a drain, connected in series with a load impedance across a supply voltage, and a control device constituting with said semiconductors a plurality of stages each comprising one of the semiconductors.

WO 98/12817 A1 discloses a switching circuit comprising cascaded transistor stages connected between a high voltage terminal and a sense resistor coupled to a low voltage terminal.

It is thus an object of the present invention to overcome or reduce at least some of the drawbacks of the prior art and to provide for a cheap alternative to a switch that comes to use between a HV potential and a LV potential (especially a LV ground potential) and that can easily be stacked depending on the isolation requirements of a high voltage system.

### Summary of Invention

One or more of the drawbacks of the prior art could be avoided or at least reduced by means of the present invention. In particular, it is provided a switch circuit for connecting and disconnecting an electrical component between a high voltage potential and a low voltage potential according to claim 1 and a switch system according to claim 11.

The switch circuit comprises a control terminal, a first connection terminal for the connection to a high voltage, HV, potential and a second connection terminal for the connection to a low voltage, LV, potential. Moreover, the switch circuit comprises a first field-effect transistor, first FET, which comprises a gate-terminal, a drain-terminal electrically connected to the first connection terminal, and a source-terminal electrically connected to the second connection terminal. Furthermore, the switch circuit comprises an adjustment unit, electrically connected to the control terminal and to the gate-terminal, the adjustment unit being adapted to alter a voltage and/or a current provided to the control terminal and to provide the altered voltage and/or current at the gate-terminal. Expressed in other words, it is provided an advantageous switch circuit that allows to connect and disconnect an electrical component between a high voltage potential and a low voltage potential, depending on the operation of the switch circuit.

An advantage of such a switch circuit is that it allows to replace the aforementioned expensive integrated switches and the additionally required protection circuits with a cheaper switch circuit that only comprises discrete electronic components. Hence, overall costs of HV systems comprising the aforementioned switches can be substantially reduced. Furthermore, via the adjustment unit, standardized and regulated current limits for the current that flows through a high voltage switch can be met as the current flowing through the switch circuit replacing the HV switch can be advantageously limited. The adjustment unit defines the gate-to-source voltage of the first FET and how much leakage current is flowing from the control terminal to the second connection terminal. This leakage current is added to the current that is flowing through a load that is being connected and disconnected by the switch circuit. Depending on how critical the leakage current is and how accurate the gate to source voltage of the first FET has to be in relation to the provided control voltage, the adjustment unit can be realized in different variants as the invention shows.

In a preferred embodiment, the first FET is realized as an enhancement-type field-effect transistor, ET-FET.

Preferably, the adjustment unit is adapted to output a voltage and/or a current as a predefined function of the voltage and/or the current that is inputted to the adjustment unit via the control terminal. Furthermore preferred, the adjustment unit is adapted to output a voltage and/or a current according to a predefined function of the voltage and/or the current that is inputted to the adjustment unit via the control terminal. Preferably, the adjustment unit is adapted to provide the altered voltage and/or the altered current at the gate-terminal of the first FET. Expressed in other words, the polarity and the absolute value of a voltage and/or of a current outputted by the adjustment unit preferably is a function of the polarity and the absolute value of the voltage and/or of the current that is inputted into the adjustment unit. Furthermore preferred, the adjustment unit comprises active and/or passive and/or electro mechanic electrical components, wherein passive components are understood to be components that cannot supply energy themselves, whereas an active component may serve as a source of energy.

Preferably, the adjustment unit is further electrically connected to the second connection terminal.

Preferably, the adjustment unit is adapted to output a voltage and/or a current that equals the inputted voltage and/or current reduced by a predefined ratio. Expressed in other words, the adjustment unit is preferably adapted to output a voltage and/or a current that equals the inputted voltage and/or current multiplied with a predefined parameter a, wherein a < 1 and a E IR.

Expressed in other words, the adjustment unit preferably is adapted to output a voltage that equals the inputted voltage reduced by a predefined ratio. Expressed in other words, the adjustment unit is preferably adapted to output a voltage that equals the inputted voltage multiplied with a predefined parameter a, wherein a < 1 and a ∈ IR.

Furthermore preferred, the adjustment unit preferably is adapted to output a current that equals the inputted current reduced by a predefined ratio. Expressed in other words, the adjustment unit is preferably adapted to output a current that equals the inputted current multiplied with a predefined parameter a, wherein a < 1 and a ∈ IR.

Preferably, altering a voltage especially comprises reducing the voltage supplied via the control terminal. In some preferred embodiments, the adjustment unit is further adapted to alter a current provided via the control terminal.

Furthermore preferred, altering a current especially comprises reducing the current supplied via the control terminal.

In a preferred embodiment, the first FET is realized as an n-Channel enhancement-type MOSFET. Such MOSFETs can cost-efficiently and compactly be integrated in a small area.

In an example not covered by the claims, the adjustment unit comprises a voltage divider, comprising a first and a second resistor, wherein a first terminal of the first resistor is electrically connected to the control terminal, and wherein a second terminal of the first resistor is electrically connected to the gate-terminal of the first FET. Furthermore, a first terminal of the second resistor is electrically connected to the second terminal of the first resistor, and a second terminal of the second resistor is electrically connected to the second connection terminal. In such an example, the adjustment unit is cost-efficient while simultaneously being effective. The voltage divider of the adjustment unit defines the voltage that is provided to the gate of the first FET by dividing the voltage that is provided to the control terminal. The current that flows through the first and the second resistor is added to the current that is switched via the switch circuit.

In a preferred embodiment, the switch circuit has the switching behavior of a MOSFET.

Furthermore preferred, the first connection terminal is adapted for the connection to the electrical component. Moreover preferred, the first connection terminal is adapted for the electrical connection to an electrical component which itself is connected to a high voltage potential.

The adjustment unit comprises a second field-effect transistor, second FET, wherein the drain-terminal of the second FET is electrically connected to the control terminal and wherein the gate-terminal and the source-terminal of the second FET are both electrically connected to the gate-terminal of the first FET respectively. With such an embodiment, the current that flows into the gate of the second FET via the gate-terminal of the same is advantageously limited and a control loop for the gate-to-source voltage of the first FET is provided. With the second FET and the resistors, the gate-to-source voltage of the first FET is controlled almost independently from the control voltage.

The second FET is realized as a depletion-type field-effect transistor, DT-FET.

Preferably, via the second FET, the current that flows into the gate of the first FET via the gate-terminal of the same is limited to a value that is smaller than 4 mA. Furthermore preferred, via the second FET, the current that flows into the gate of the first FET via the gate-terminal of the same is limited to a value that is smaller than a predefined value. Preferably, the predefined value is chosen such that the leakage current is acceptable for the system the switch circuit is used in when the leakage current is being added to the current that is being switched.

The voltage that drops across the electric path between the gate-terminals of the first FET and the second FET advantageously represents the gate-to-source voltage of the second FET and defines the on-state resistance, R_{DS_ON} of the same. Hence, when a voltage is provided to the control terminal that is significantly higher than the voltage that is provided to the second connection terminal, an equilibrated voltage is provided to the gate-terminal of the first FET.

Preferably, the second FET is realized as an n-Channel depletion-type MOSFET. Such MOSFETs can cost-efficiently and compactly be integrated in a small area.

The electrical connection between the gate-terminal of the second FET and the gate-terminal of the first FET comprises a primary resistor connected in series with the gate-terminals. Such a resistor can advantageously be used to set the gate-to-source voltage of the second FET to a predefined voltage or to fall into a predefined range of voltages.

A first terminal of a secondary resistor is electrically connected to the gate-terminal of the second FET and a second terminal of the secondary resistor is electrically connected to the second connection terminal. In such an embodiment, the combination of the second FET, the primary resistor and the secondary resistor provides for a precisely controlled equilibrated voltage that is supplied to the gate of the first FET.

Preferably, the electrical connection between the drain-terminal of the second FET and the control terminal comprises a tertiary resistor. Such a tertiary resistor serves as a series resistor which protects the discrete components of the switch circuit and could be or is also used to limit the leakage current.

In a preferred embodiment, the cathode of a first diode is electrically connected to the first connection terminal and the anode of the first diode is electrically connected to the second connection terminal. With such a first diode, the first FET and the second FET are advantageously protected against an overvoltage which otherwise would may destroy the transistors. Preferably, the characteristics and properties of the first diode are chosen according to the application requirements and the other components of the switch circuit.

Preferably, the cathode of a second diode is electrically connected to the gate-terminal of the first FET and the anode of the second diode is electrically connected to the second connection terminal. In such an embodiment, the switch circuit and especially the transistors of the same are even better protected against overvoltage.

In a preferred embodiment, the first and/or the second diode is realized as an ESD diode or as a suppressor diode. Furthermore preferred, the first and/or the second diode is realized as an ESD protection diode, as a snubber diode, as a commutating diode, as a freewheeling diode, as a suppression diode, as a clamp diode, or as a catch diode. Such diodes can advantageously be used to eliminate a so called flyback, which is the sudden voltage spike seen across an inductive load when its supply current is suddenly reduced or interrupted. In such an embodiment, the switch circuit is well protected against overvoltage.

Furthermore preferred, the first and/or the second diode is realized as a Zener diode. A Zener diode or Z-diode allows for a current to flow not only from its anode to its cathode, but also in the reverse direction, when the so-called Zener voltage is reached. Zener diodes have a highly doped p-n junction and are advantageously configured to reliably operate in the breakdown region which further increases the protection of the switch circuit - especially of the first FET and the second FET - against an overcurrent and an overvoltage.

In a furthermore preferred embodiment, a first terminal of a capacitor is electrically connected to the gate-terminal of the first FET and a second terminal of the capacitor is electrically connected to the second connection terminal. Such a capacitor ensures a safe and stable switching of the switch circuit.

Preferably, the control terminal is electrically connected to the anode of a third diode. Such a third diode is used to allow for the switch circuit to be stacked with other switch circuits. Preferably, the cathode of the third diode is electrically connected to the control terminal of another switch circuit that is according to the invention. Preferably, the third diode is adapted to block a voltage supplied by the control terminal of the switch circuit the third diode is connected to in order to protect the discrete electrical components of the switch circuit from this voltage.

Moreover, a switch system is provided, the switch system comprising at least two switch circuits that are configured according to the invention respectively, wherein the cathode of the third diode of one of the at least two switch circuits is electrically connected to the control terminal of the other one of the at least two switch circuits. In such an embodiment, at least two switch circuits are advantageously stacked without that further components are required.

Further aspects of the present invention could be learned from the dependent claims or the following description.

### Brief Description of the Drawings

Features will become apparent to those of ordinary skill in the art by describing in detail exemplary embodiments with reference to the attached drawings in which:
- Fig. 1: illustrates a first embodiment of a switch circuit that is according to the invention;
- Fig. 2: illustrates a second embodiment of a switch circuit that does not form part of the invention;
- Fig. 3: illustrates a third embodiment of a switch circuit that is according to the invention;
- Fig. 4: illustrates an embodiment of a switch system that is according to the invention, the switch system comprising three switch circuits that are according to the third embodiment of the invention, and
- Fig. 5: illustrates an embodiment of a switch circuit that is according to the invention and shown in a connected state.

### Detailed Description of the invention

Reference will now be made in detail to embodiments, examples of which are illustrated in the accompanying drawings. Effects and features of the exemplary embodiments, and implementation methods thereof will be described with reference to the accompanying drawings. In the figures, like reference numerals denote like elements, and redundant descriptions are omitted. As used herein, the term "and/or" includes any and all combinations of one or more of the associated listed items. Further, the use of "may" when describing embodiments of the present invention refers to "one or more embodiments of the present invention."

It will be understood that although the terms "first", "second" and "third" are used to describe various elements, these elements should not be limited by these terms. These terms are only used to distinguish one element from another element. For example, a first element may be named a second element and, similarly, a second element may be named a first element, without departing from the scope of the present invention.

In the following description of embodiments of the present invention, the terms of a singular form may include plural forms unless the context clearly indicates otherwise.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

It will be understood that when an element or layer is referred to as being "on," "connected to," or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

As used herein, the term "substantially," "about," and similar terms are used as terms of approximation and not as terms of degree, and are intended to account for the inherent deviations in measured or calculated values that would be recognized by those of ordinary skill in the art.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein.

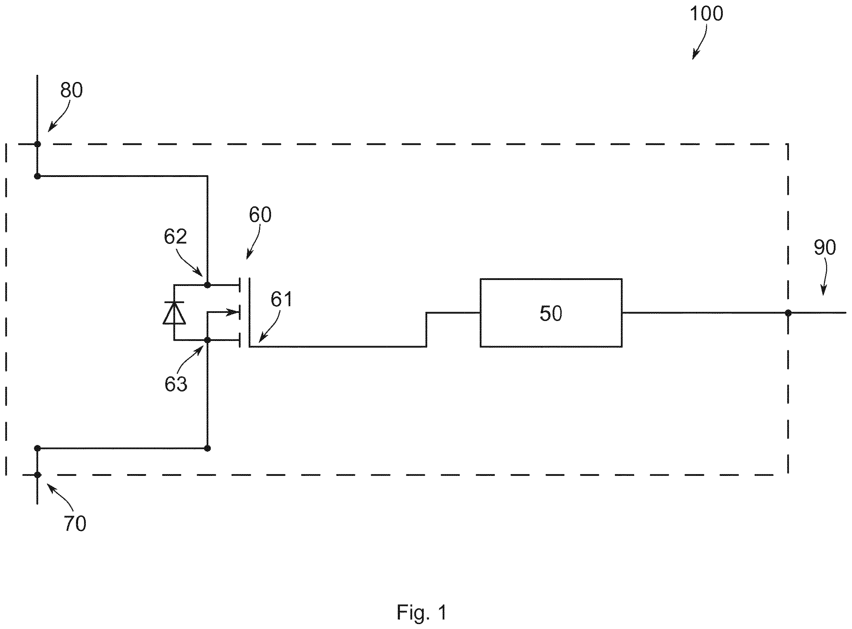

Figure 1 illustrates a first embodiment of a switch circuit 100 that is according to the invention.

The switch circuit 100 functions as a switch that is adapted for connecting and disconnecting an electrical component, in this embodiment exemplarily an impedance, between a high voltage potential and a low voltage potential. Expressed in other words, via the switch circuit 100, it is possible to connect and disconnect an electrical component between a high voltage potential and a low voltage potential, e.g. between different potentials of a high voltage system or network or between a positive and negative pole of a high voltage power source. For this purpose, the switch circuit 100 itself may be directly connected to one of the aforementioned potentials (to the high voltage potential or to the low voltage potential), as for example to a low voltage potential, e.g. to a ground potential and to a terminal of the electrical component, which itself is electrically connected to the other one of the aforementioned potentials via another terminal.

Hence - when connected to a high voltage potential or to a low voltage potential via the switch circuit 100 - the switch circuit 100 allows to disconnect and separate the electrical component from this high or low voltage potential respectively. Hence, the switch circuit 100 is adapted to reversibly provide for an electrical connection between an electrical component and a high voltage system or network. Expressed in other words, via the switch circuit 100, an electrical component can be connected into and disconnected from an electrical path between a high voltage potential and a low voltage potential.

The switch circuit 100 comprises a control terminal 90, a first connection terminal 80 for the connection to a high voltage, HV, potential or to an electrical component that is connected to a high voltage potential and a second connection terminal 70 for the connection to a low voltage, LV, potential. Via the control terminal 90, the switch circuit 100 can be transferred into an on-state, in which a current may flow from the first connection terminal 80 to the second connection terminal 70 or vice versa. Moreover, also via the control terminal 90, the switch circuit 100 can be transferred into an off-state, in which a current can not flow from the first connection terminal 80 to the second connection terminal 70 or vice versa and is blocked. Whether the switch circuit 100 is in the on-state or the off-state depends on the voltage that is supplied to the control terminal 90 of the switch circuit 100.

As mentioned, the first connection terminal 80 is further adapted for the electrical connection to an electrical component, which in this embodiment exemplarily is an impedance. Moreover, the switch circuit 100 - in this first embodiment - comprises a first field-effect transistor, first FET, which in this first embodiment is exemplarily realized as an enhancement-type field-effect transistor, ET-FET 60, which comprises a gate-terminal 61, a drain-terminal 62 electrically connected to the first connection terminal 80, and a source-terminal 63 electrically connected to the second connection terminal 70. In this embodiment, the ET-FET 60 is exemplarily realized as an n-Channel enhancement-type MOSFET. However, also any other ET-FET may come to use.

Moreover, the switch circuit 100 comprises an adjustment unit 50, electrically connected to the control terminal 90 and to the gate-terminal 61, the adjustment unit 50 in this first embodiment being adapted to alter a voltage provided to the control terminal 90 and to provide the altered voltage at the gate-terminal 61 of the ET-FET 60. Expressed in other words, the adjustment unit 50 is provided in between the control terminal 90 of the switch circuit 100 and the gate-terminal 61 of the ET-FET 60, wherein an input terminal of the adjustment unit 50 is electrically connected to the control terminal 90 and wherein an output terminal of the adjustment unit 50 is electrically connected to the gate-terminal 61 of the ET-FET 60.

In this embodiment, the adjustment unit 50 is exemplarily adapted to reduce a voltage that is provided to the control terminal 90 of the switch circuit 100. In other embodiments, the adjustment unit 50 may be adapted to alter, especially reduce the current that is provided to the control terminal 90 of the switch circuit 100. Moreover, in some embodiments, the adjustment unit 50 is adapted to alter, especially reduce the current and the voltage that is provided to the control terminal 90 of the switch circuit 100 and to provide the reduced current and voltage at the gate-terminal 61 of the ET-FET 60.

In this embodiment, the adjustment unit 50 is adapted to reduce the voltage that is provided to the control terminal from an external side and to provide the reduced voltage at the gate-terminal of the ET-FET 60.

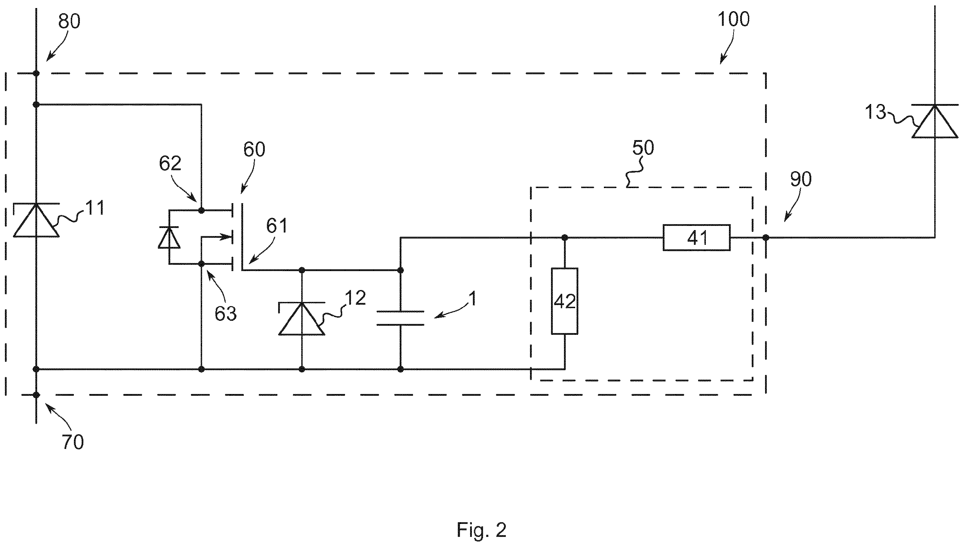

Figure 2 illustrates a second embodiment of a switch circuit 100 that does not form part of the invention but represents background art that is useful for understanding the invention and that is substantially identical to the first embodiment shown in figure 1. Hence, as mentioned, like reference numerals denote like elements. The embodiment shown in figure 2 represents a switch circuit 100 that is not sensitive to leakage currents. In this second embodiment, the adjustment unit 50 comprises a voltage divider, comprising a first and a second resistor 41, 42. A first terminal of the first resistor 41 is electrically connected to the control terminal 90 and a second terminal of the first resistor 41 is electrically connected to the gate-terminal 61 of the ET-FET 60. Moreover, a first terminal of the second resistor 42 is electrically connected to the second terminal of the first resistor 41, and a second terminal of the second resistor 42 is electrically connected to the second connection terminal 70. Expressed in other words, in this embodiment, the electrical path connecting the control terminal 90 of the switch circuit 100 and the gate-terminal 61 of the ET-FET 60 comprises a first resistor 41. Moreover, a first terminal of a second resistor 42 is electrically connected to the aforementioned electrical path, in between the gate-terminal 61 of the ET-FET 60 and the first resistor 41. The second terminal of the second resistor 42 is electrically connected to the second connection terminal 70 of the switch circuit 100.

Moreover, in this second embodiment, the switch circuit 100 comprises three diodes, a first, a second and a third diode 11, 12, 13. The cathode of the first diode 11 is electrically connected to the first connection terminal 80 of the switch circuit 100, wherein the anode of this first diode 11 is electrically connected to the second connection terminal 70 of the switch circuit 100. The cathode of the second diode 12 is electrically connected to the gate-terminal 61 of the ET-FET 60 and the anode of the second diode 12 is electrically connected to the second connection terminal 70. In this embodiment, the first and the second diode 11, 12 are exemplarily both realized as ESD protection diodes. Further, the control terminal 90 is electrically connected to the anode of the third diode 13. In this second embodiment, the third diode 13 is a standardized semiconductor diode 13. However, any other diode can come to use as such a third diode 13.

In this second embodiment, the voltage divider, comprising the first and the second resistor 41, 42, defines the voltage provided to the gate-terminal 61 of the ET-FET 60 and hence to the gate of the ET-FET 60. The current through the first and the second resistor 41, 42 and the leakage current trough the first ESD protection diode 11 is added to the current that is being switched by the switch circuit 100, hence to the current flowing through the first connection terminal 80 and the second connection terminal 70.

Moreover, in this second embodiment, a first terminal of a capacitor 1 is electrically connected to the gate-terminal 61 of the ET-FET 60 and a second terminal of the capacitor 1 is electrically connected to the second connection terminal 70. Hence, the capacitor 1 is connected in parallel to the second diode 12 and - in this second embodiment - also exemplarily in parallel to the second resistor 42 of the voltage divider of the adjustment unit 50. This capacitor 1 ensures a safe and stable switching behavior of the switch circuit 100.

Via the third diode 13, the switch circuit 100 can be stacked with another switch circuit 100 that is according to the invention. In more detail, the cathode of the third diode 13 can be electrically connected to the control terminal 90 of another switch circuit 100 to stack two switch circuits 100 that are according to the invention.

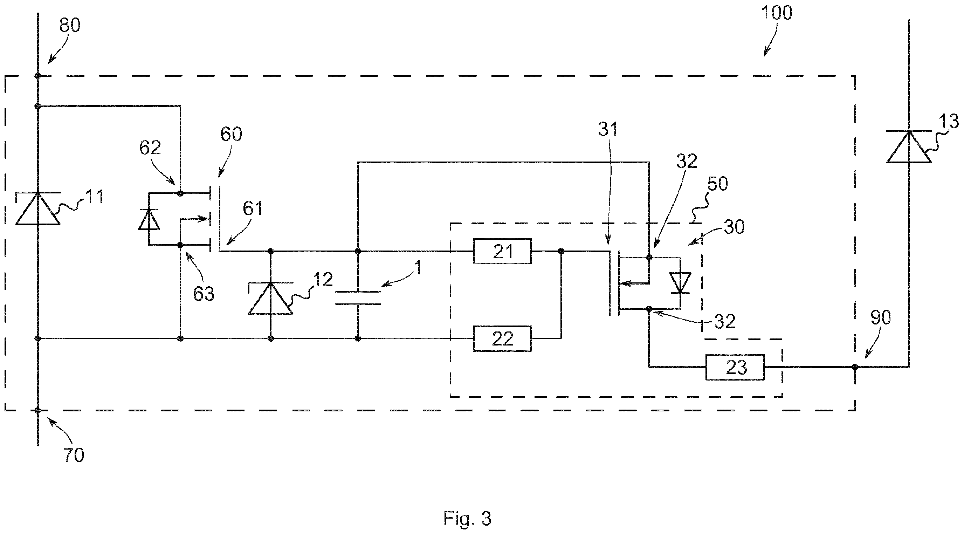

Figure 3 illustrates a third embodiment of a switch circuit 100 that is according to the invention. In this third embodiment, the adjustment unit 50 is realized such that the switch circuit 100 is highly sensitive to leakage currents. In this third embodiment, instead of a voltage divider, the adjustment unit 50 comprises a second field-effect transistor, second FET, which in this embodiment is exemplarily realized as a depletion-type field-effect transistor, DT-FET 30, wherein the drain-terminal 32 of the DT-FET 30 is electrically connected to the control terminal 90 of the switch circuit 100 and wherein the gate-terminal 31 and the source-terminal 33 of the DT-FET 30 are both electrically connected to the gate-terminal 61 of the ET-FET 60 respectively. Expressed in other words, in this third embodiment, the adjustment unit 50 does not comprise a voltage divider with the aforementioned first and second resistor 41, 42 (see figure 2), but a depletion-type field-effect transistor, DT-FET 30. In this embodiment, the DT-FET 30 is exemplarily realized as an n-Channel depletion-type MOSFET. However, any other DT-FET 30 may come to use.

Moreover, in this third embodiment, the adjustment unit 50 further comprises three resistors 21, 22, 23, namely a primary resistor 21, a secondary resistor 22 and a tertiary resistor 23. However, these three resistors 21, 22, 23 do not necessarily need to belong to the adjustment unit 50 but can also form part of the switch circuit 100 in general. Moreover, more or fewer resistors can come to use.

The electrical connection between the gate-terminal 31 of the DT-FET 30 and the gate-terminal 61 of the ET-FET 60 comprises the primary resistor 21 that is connected in series with the gate-terminals 31, 61 of the DT-FET 30 and the ET-FET 60. Hence, a first terminal of the primary resistor 21 is electrically connected to the gate-terminal 31 of the DT-FET 30, while the second terminal of the primary resistor 21 is electrically connected to the gate-terminal 61 of the ET-FET 60.

A first terminal of the secondary resistor 22 is electrically connected to the gate-terminal 31 of the DT-FET 30 and a second terminal of the secondary resistor 22 is electrically connected to the second connection terminal 70 of the switch circuit 100. Furthermore, the electrical connection between the drain-terminal 32 of the DT-FET 30 and the control terminal 90 comprises the tertiary resistor 23. The tertiary resistor 23 serves as a protection resistor which has a resistance value that is sufficient to protect the other discrete components of the switch circuit 100 in case the voltage or current supplied to the control terminal 90 of the switch circuit 100 exceeds an admissible threshold. The aforementioned resistance value of the tertiary resistor 23 is adjusted to this admissible threshold. Expressed in other words, a first terminal of the tertiary resistor 23 is electrically connected to the control terminal 90 of the switch circuit 100 while a second terminal of the tertiary resistor 23 is electrically connected to the drain-terminal 32 of the DT-FET 30.

In this third embodiment, the DT-FET 30 is used to limit the current into the control terminal 90 of the switch circuit 100. When a voltage is supplied to the control terminal 90 of the switch circuit 100, a voltage drops across the primary resistor 21 of the switch circuit 100 and provides for a gate-to-source voltage U_{GS} for the DT-FET 30 that defines the on-state resistance R_{DS_ON} of the DT-FET 30. Expressed in other words, the voltage that drops across the primary resistor 21 of the switch circuit 100 defines the average resistance of the channel of the DT-FET 30.

If the voltage that is supplied to the control terminal 90 of the switch circuit 100 is significantly higher than the voltage that is supplied to the second connection terminal 70, the combination of the DT-FET 30 and the primary and secondary resistor 21, 22 creates an equilibrated voltage that is supplied to the gate-terminal 61 of the ET-FET 60. The values of the primary and the secondary resistor 21, 22 are chosen such that depending on the control voltage that is supplied to the control terminal 90, the voltage that drops between the gate-terminal 61 and the source-terminal 63 of the ET-FET 60 transfers the same into a conducting state, transferring the switch circuit 100 into the on-state described hereinbefore.

There is no need to mention that also in this third embodiment, the switch circuit 100 comprises the first, second and third diode 11, 12, 13 as described hereinbefore. Also in this third embodiment, the first, second and third diode 11, 12, 13 are connected to the other components of the switch circuit 100 as described hereinbefore with respect to figure 2 respectively. Moreover, also in this third embodiment, a first terminal of a capacitor 1 is electrically connected to the gate-terminal 61 of the ET-FET 60 and a second terminal of the capacitor 1 is electrically connected to the second connection terminal 70.

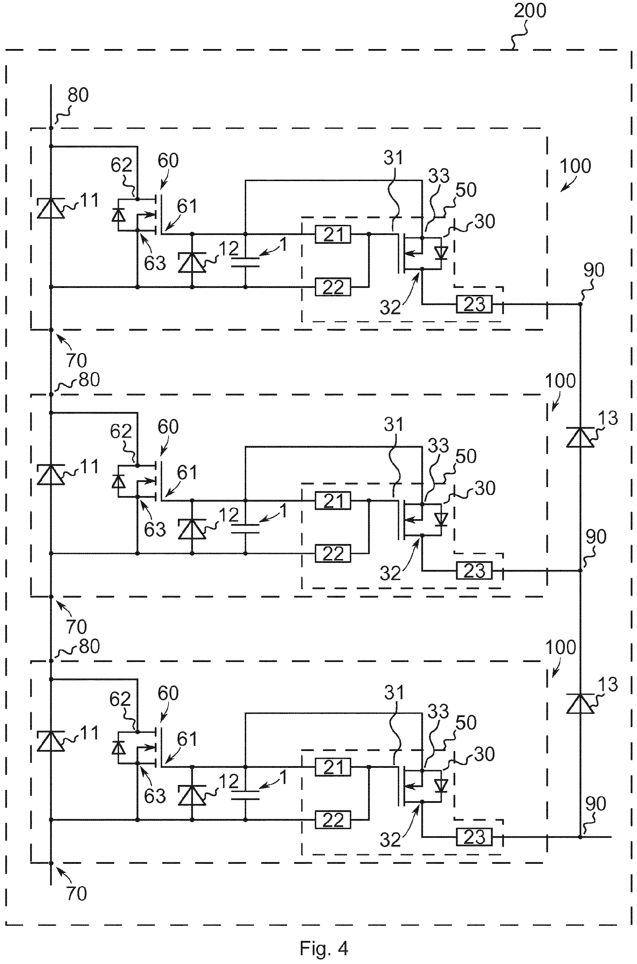

In figure 4, it is illustrated an embodiment of a switch system 200 that is according to the invention, the switch system 200 comprising three switch circuits 100 that are exemplarily according to the third embodiment of the invention described hereinbefore. For the following description, the lowermost switch circuit 100 shown in figure 4 is denoted the first switch circuit 100, the uppermost switch circuit 100 shown in figure 4 is denoted the third switch circuit 100, and the switch circuit 100 in between the first and the third switch circuit 100 is denoted the second switch circuit 100.

In this switch system 200, the cathode of the third diode 13 of the first switch circuit 100 is electrically connected to the control terminal 90 of the second switch circuit 100. The cathode of the third diode 13 of the second switch circuit 100 is electrically connected to the control terminal 90 of the third switch circuit 100. Furthermore, in this embodiment, the second connection terminal 70 of the first switch circuit 100 is exemplarily electrically connected to a low voltage, LV, ground potential (not shown). The first connection terminal 80 of the first switch circuit 100 is electrically connected to the second connection terminal 70 of the second switch circuit 100. Furthermore, the first connection terminal 80 of the second switch circuit 100 is electrically connected to the second connection terminal 70 of the third switch circuit 100. Moreover, in this embodiment of the switch system 200, the first connection terminal 80 of the third switch circuit 100 is exemplarily electrically connected to an electrical component that shall be connectable and disconnectable from a high voltage potential via the switch system 200 (not shown). Hence, the electrical component is electrically connected to a HV potential (not shown).

Expressed in other words, within the switch system 200 shown in figure 4, a stack of HV switch circuits 100 is implemented in a way that the second connection terminal 70 of the first switch circuit 100 is connected (pulled down) to the common GND - meaning the common low voltage ground potential - of a control logic. If the full stack of HV switch circuits 100 of the switch system 200 shall be turned on and hence be transferred to a so called low ohmic state or on-state, a voltage is supplied to the control terminal 90 of the first switch circuit 100 which is high enough that the residual voltage that is supplied to (arrives at) the ET-FET 60 of the first switch circuit 100 - compared to the voltage provided to the source-terminal 63 of the ET-FET 60 - turns on the ET-FET 60, transferring the same into a conducting state.

In such a state, the potential at the first connection terminal 80 of the first switch circuit 100 is almost as low as the potential at the second connection terminal 70 of the first switch circuit 100. Moreover, in such a state, the potential at the control terminal 90 of the second switch circuit 100 is equal to the potential at the control terminal 90 of the first switch circuit 100, merely reduced by the amount of the forward voltage dropping across the third diode 13 of the first switch circuit 100. Hence, in such a state, the potential at the control terminal 90 of the second switch circuit 100 is equal to the potential at the control terminal 90 of the first switch circuit 100, minus the absolute value of the forward voltage that drops across the third diode 13 of the first switch circuit 100. Moreover, the potential at the control terminal 90 of the third switch circuit 100 is equal to the potential at the control terminal 90 of the first switch circuit 100, minus the amount or absolute value of the forward voltage that drops across the third diode 13 of the first switch circuit 100 and minus the amount or absolute value of the forward voltage that drops across the third diode 13 of the second switch circuit 100. Expressed in other words, in a nonconductive state, the source-potential of the ET-FET 60 of a switch circuit 100 is provided to the cathode of the third diode 13 that is connected to the control terminal 90 of the switch circuit 100 the respective ET-FET 60 is arranged in. Hence, this third diode 13 blocks the voltage provided at the aforementioned source-potential, as otherwise the voltage provided at the first connection terminal 80 of the third switch circuit 100 would be fed back to a control unit (not visible in figure 4) which may cause damage to the same.

For this reason, also the second and third switch circuits 100 are conductive. In order to transfer all three switch circuits 100 into a conductive state, the voltage provided to the control terminal 90 of the first switch circuit 100 needs to have a value that is high enough so that the residual voltage supplied to the ET-FET 60 of the third switch circuit 100 is high enough to transfer the ET-FET 60 of the third switch circuit 100 into a conductive state. In more detail, the aforementioned value of the voltage provided to the control terminal 90 of the first switch circuit 100 needs to have a value that is high enough so that the gate-to-source voltage U_{GS} supplied to the gate-terminal 61 of the ET-FET 60 of the third switch circuit 100 turns on the same so that the aforementioned ET-FET 60 becomes low-ohmic, hence transferring the third switch circuit 100 into an on-state.

In this embodiment, the properties and the dimension of the first diode 11 of the first switch circuit 100, especially the voltage withstand capability of the first diode 11 of the first switch circuit 100 is sufficient to protect the ET-FET 60 of the first switch circuit 100 from an over-voltage. Furthermore, the properties and the dimension of the first diode 11 of the second switch circuit 100, especially the voltage withstand capability of the first diode 11 of the second switch circuit 100 is sufficient to protect the ET-FET 60 of the second switch circuit 100 from an over-voltage. Likewise, the properties and the dimension of the first diode 11 of the third switch circuit 100, especially the voltage withstand capability of the first diode 11 of the third switch circuit 100 is sufficient to protect the ET-FET 60 of the third switch circuit 100 from an over-voltage.

In principal, when the ET-FETs 60 of the first, second and third switch circuit 100 are in a nonconductive state, substantially the same voltage should drop across the ET-FETs 60 of the switch circuits 100 respectively. The first diodes 11 assure that a maximally tolerable Drain-Source-Voltage of the ET-FETs 60 is not exceeded, if the voltage dropping across the series connected ET-FETs 60 is, for some reason, not equally distributed.

A benefit of such switch circuits 100 is that the creepage and clearance requirements are less stringent within each HV switch circuit 100. The ET-FETs 60, and if required the first diodes 11 of each HV switch circuit 100 define the maximum voltage across each HV switch circuit 100. Additionally, the amount of HV switch circuits 100 can be optimized and adjusted to the required withstand voltage capability of a specific application. Even though each switch circuit 100 comprises a plurality of components, the total costs of production and manufacturing for a switch system 200 as the one shown in figure 4 is still lower compared to state of the art switches.

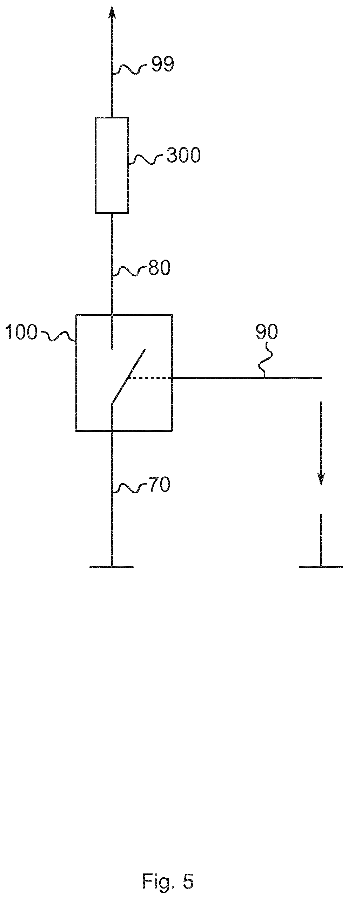

In figure 5, it is illustrated an embodiment of a switch circuit 100 that is according to the invention and that is connected to an electrical component 300, which in figure 5 is exemplarily realized as a resistor. The embodiment of a switch circuit 100 shown in figure 5 exemplarily corresponds to the first embodiment of a switch circuit 100 as shown in figure 1 and as described hereinbefore. However, the embodiment shown in figure 5 may also correspond to the second embodiment or to the third embodiment of a switch circuit 100 as shown in figures 2 and 3 or to any other embodiment of a switch circuit that is according to the invention.

In figure 5, the electrical component 300 has two terminals. A first terminal of the electrical component 300 is exemplarily electrically connected to a high voltage, HV, potential of a high voltage network, which in figure 5 is exemplarily indicated via an arrow 99. The second terminal of the electrical component 300 is electrically connected to the first connection terminal 80 of the switch circuit 100. The second connection terminal 70 of the switch circuit 100 is electrically connected to a low voltage, LV, potential. Via a voltage supplied to the control terminal 90 of the switch circuit 100, the switch circuit 100 may be transferred into an on-state, in which a current may flow from the first connection terminal 80 to the second connection terminal 70 or vice versa.

## Claims

1. A switch circuit (100) for connecting and disconnecting an electrical component between a high voltage potential and a low voltage potential, the switch circuit (100) comprising:
a control terminal (90);
a first connection terminal (80) for the connection to a high voltage, HV, potential;
a second connection terminal (70) for the connection to a low voltage, LV, potential;
a first field-effect transistor, first FET (60), comprising
a gate-terminal (61),
a drain-terminal (62) electrically connected to the first connection terminal (80), and
a source-terminal (63) electrically connected to the second connection terminal (70); and
an adjustment unit (50), electrically connected to the control terminal (90) and the gate-terminal (61), the adjustment unit (50) being adapted to alter a voltage and/or a current provided to the control terminal (90) and to provide the altered voltage and/or current at the gate-terminal (61), wherein the adjustment unit (50) comprises a second field-effect transistor, second FET (30), wherein the drain-terminal (32) of the second FET (30) is electrically connected to the control terminal (90);
**characterized in that**
the second FET is realized as a depletion-type field-effect transistor; and **in that** the gate-terminal (31) and the source-terminal (33) of the second FET (30) are both electrically connected to the gate-terminal (61) of the first FET (60) respectively, wherein the electrical connection between the gate-terminal (31) of the second FET (30) and the gate-terminal (61) of the first FET (60) comprises a primary resistor (21) connected in series with the gate-terminals (31, 61); and
the switch circuit (100) further comprising a secondary resistor (22), wherein a first terminal of the secondary resistor (22) is electrically connected to the gate-terminal (31) of the second FET (30) and wherein a second terminal of the secondary resistor (22) is electrically connected to the second connection terminal (70).

2. The switch circuit (100) of claim 1, wherein the first FET (60) is realized as an n-Channel enhancement-type MOSFET.

3. The switch circuit (100) of claim 1, wherein the second FET (30) is realized as an n-Channel depletion-type MOSFET.

4. The switch circuit (100) of one of the previous claims, wherein the electrical connection between the drain-terminal (32) of the second FET (30) and the control terminal (90) comprises a tertiary resistor (23).

5. The switch circuit (100) of one of the previous claims, further comprising a first diode (11), wherein the cathode of the first diode (11) is electrically connected to the first connection terminal (80) and wherein the anode of the first diode (11) is electrically connected to the second connection terminal (70).

6. The switch circuit (100) of one of the previous claims, further comprising a second diode (12), wherein the cathode of the second diode (12) is electrically connected to the gate-terminal (61) of the first FET (60) and wherein the anode of the second diode (12) is electrically connected to the second connection terminal (70).

7. The switch circuit (100) of claim 5 or 6, wherein the first and/or the second diode (11, 12) is realized as an ESD diode or as a suppressor diode.

8. The switch circuit (100) of one of the claims 5 to 7, wherein the first and/or the second diode (11, 12) is realized as a Zener diode.

9. The switch circuit (100) of one of the previous claims, further comprising a capacitor (1), wherein a first terminal of the capacitor (1) is electrically connected to the gate-terminal (61) of the first FET (60) and wherein a second terminal of the capacitor (1) is electrically connected to the second connection terminal (70).

10. The switch circuit (100) of one of the previous claims, further comprising a third diode (13), wherein the control terminal (90) is electrically connected to the anode of the third diode (13).

11. A switch system (200), comprising at least two switch circuits (100) that are configured according to claim 10 respectively, wherein the cathode of the third diode (13) of one of the at least two switch circuits (100) is electrically connected to the control terminal (90) of the other one of the at least two switch circuits (100).

## Patentansprüche

1. Schaltkreis (100) zum Verbinden und Trennen einer elektrischen Komponente zwischen einem Hochspannungspotential und einem Niederspannungspotential, wobei der Schaltkreis (100) umfasst:
einen Steueranschluss (90);
einen ersten Verbindungsanschluss (80) für die Verbindung mit einem Hochspannungs-, LV,-Potenzial;
einen zweiten Verbindungsanschluss (70) für die Verbindung mit einem Niederspannungs-, LV,-Potenzial;
einen ersten Feldeffekttransistor, erster FET (60), umfassend
einen Gate-Anschluss (61),
einen Drain-Anschluss (62), der elektrisch mit dem ersten Verbindungsanschluss (80) verbunden ist, und
einen Quellenanschluss (63), der elektrisch mit dem zweiten Verbindungsanschluss (70) verbunden ist; und
eine Einstelleinheit (50), die elektrisch mit dem Steueranschluss (90) und dem Gate-Anschluss (61) verbunden ist, wobei die Einstelleinheit (50) angepasst ist, um eine Spannung und/oder einen Strom zu ändern, die bzw. der dem Steueranschluss (90) zugeführt wird, und um die geänderte Spannung und/oder den geänderten Strom am Gate-Anschluss (61) bereitzustellen, wobei die Einstelleinheit (50) einen zweiten Feldeffekttransistor, zweiten FET (30), umfasst, wobei der Drain-Anschluss (32) des zweiten FET (30) elektrisch mit dem Steueranschluss (90) verbunden ist;
**dadurch gekennzeichnet, dass**
der zweite FET als Feldeffekttransistor vom Verarmungstyp realisiert ist; und dass der Gate-Anschluss (31) und der Source-Anschluss (33) des zweiten FET (30) beide jeweils mit dem Gate-Anschluss (61) des ersten FET (60) elektrisch verbunden sind, wobei die elektrische Verbindung zwischen dem Gate-Anschluss (31) des zweiten FET (30) und dem Gate-Anschluss (61) des ersten FET (60) einen Primärwiderstand (21) umfasst, der in Reihe mit den Gate-Anschlüssen (31, 61) geschaltet ist; und
der Schaltkreis (100) weiterhin einen sekundären Widerstand (22) umfasst, wobei ein erster Anschluss des sekundären Widerstands (22) elektrisch mit dem Gate-Anschluss (31) des zweiten FET (30) verbunden ist und wobei ein zweiter Anschluss des sekundären Widerstands (22) elektrisch mit dem zweiten Verbindungsanschluss (70) verbunden ist.

2. Schaltkreis (100) nach Anspruch 1, wobei der erste FET (60) als n-Kanal-MOSFET vom Enhancement-Typ ausgeführt ist.

3. Schaltkreis (100) nach Anspruch 1, wobei der zweite FET (30) als n-Kanal-MOSFET vom Verarmungstyp ausgeführt ist.

4. Schaltkreis (100) nach einem der vorhergehenden Ansprüche, wobei die elektrische Verbindung zwischen dem Drain-Anschluss (32) des zweiten FET (30) und dem Steueranschluss (90) einen Tertiärwiderstand (23) umfasst.

5. Schaltkreis (100) nach einem der vorhergehenden Ansprüche, der ferner eine erste Diode (11) umfasst, wobei die Kathode der ersten Diode (11) elektrisch mit dem ersten Verbindungsanschluss (80) verbunden ist und wobei die Anode der ersten Diode (11) elektrisch mit dem zweiten Verbindungsanschluss (70) verbunden ist.

6. Schaltkreis (100) nach einem der vorhergehenden Ansprüche, der ferner eine zweite Diode (12) umfasst, wobei die Kathode der zweiten Diode (12) elektrisch mit dem Gate-Anschluss (61) des ersten FET (60) verbunden ist und wobei die Anode der zweiten Diode (12) elektrisch mit dem zweiten Verbindungsanschluss (70) verbunden ist.

7. Schaltkreis (100) nach Anspruch 5 oder 6, wobei die erste und/oder die zweite Diode (11, 12) als ESD-Diode oder als Suppressordiode ausgeführt ist.

8. Schaltkreis (100) nach einem der Ansprüche 5 bis 7, wobei die erste und/oder die zweite Diode (11, 12) als Zener-Diode ausgeführt ist.

9. Schaltkreis (100) nach einem der vorhergehenden Ansprüche, der ferner einen Kondensator (1) umfasst, wobei ein erster Anschluss des Kondensators (1) elektrisch mit dem Gate-Anschluss (61) des ersten FET (60) verbunden ist und wobei ein zweiter Anschluss des Kondensators (1) elektrisch mit dem zweiten Verbindungsanschluss (70) verbunden ist.

10. Schaltkreis (100) nach einem der vorhergehenden Ansprüche, der ferner eine dritte Diode (13) umfasst, wobei der Steueranschluss (90) elektrisch mit der Anode der dritten Diode (13) verbunden ist.

11. Schaltsystem (200) mit mindestens zwei Schaltkreisen (100), die jeweils nach Anspruch 10 konfiguriert sind, wobei die Kathode der dritten Diode (13) eines der mindestens zwei Schaltkreise (100) elektrisch mit dem Steueranschluss (90) des anderen der mindestens zwei Schaltkreise (100) verbunden ist.

## Revendications

1. Circuit de commutation (100) pour connecter et déconnecter un composant électrique entre un potentiel haute tension et un potentiel basse tension, le circuit de commutation (100) comprenant :
une borne de commande (90) ;
une première borne de connexion (80) pour la connexion à un potentiel haute tension, HV ;
une seconde borne de connexion (70) pour la connexion à un potentiel basse tension, LV ;
un premier transistor à effet de champ, premier FET (60), comprenant
une borne de gâchette (61),
une borne de drain (62) connectée électriquement à la première borne de connexion (80), et
une borne de source (63) connectée électriquement à la seconde borne de connexion (70) ; et
une unité de réglage (50), connectée électriquement à la borne de commande (90) et à la borne de gâchette (61), l'unité de réglage (50) étant adaptée pour modifier une tension et/ou un courant fournis à la borne de commande (90) et pour fournir la tension et/ou le courant modifiés à la borne de gâchette (61), dans lequel l'unité de réglage (50) comprend un second transistor à effet de champ, second FET (30),
dans lequel la borne de drain (32) du second FET (30) est connectée électriquement à la borne de commande (90) ;
**caractérisé en ce que**
le second FET prend la forme d'un transistor à effet de champ de type à appauvrissement ; et **en ce que** la borne de gâchette (31) et la borne de source (33) du second FET (30) sont toutes deux connectées électriquement à la borne de gâchette (61) du premier FET (60) respectivement, dans lequel la connexion électrique entre la borne de gâchette (31) du second FET (30) et la borne de gâchette (61) du premier FET (60) comprend une résistance primaire (21) connectée en série aux bornes de gâchette (31, 61) ; et
le circuit de commutation (100) comprenant en outre une résistance secondaire (22), dans lequel une première borne de la résistance secondaire (22) est connectée électriquement à la borne de gâchette (31) du second FET (30) et dans lequel une seconde borne de la résistance secondaire (22) est connectée électriquement à la seconde borne de connexion (70).

2. Circuit de commutation (100) selon la revendication 1, dans lequel le premier FET (60) prend la forme d'un MOSFET à canal N de type à enrichissement.

3. Circuit de commutation (100) selon la revendication 1, dans lequel le second FET (30) prend la forme d'un MOSFET à canal N de type à appauvrissement.

4. Circuit de commutation (100) selon l'une des revendications précédentes, dans lequel la connexion électrique entre la borne de drain (32) du second FET (30) et la borne de commande (90) comprend une résistance tertiaire (23).

5. Circuit de commutation (100) selon l'une des revendications précédentes, comprenant en outre une première diode (11), dans lequel la cathode de la première diode (11) est connectée électriquement à la première borne de connexion (80) et dans lequel l'anode de la première diode (11) est connectée électriquement à la seconde borne de connexion (70).

6. Circuit de commutation (100) selon l'une des revendications précédentes, comprenant en outre une deuxième diode (12), dans lequel la cathode de la deuxième diode (12) est connectée électriquement à la borne de gâchette (61) du premier FET (60) et dans lequel l'anode de la deuxième diode (12) est connectée électriquement à la seconde borne de connexion (70).

7. Circuit de commutation (100) selon la revendication 5 ou 6, dans lequel la première et/ou la deuxième diode (11, 12) prennent la forme d'une diode ESD ou d'une diode suppresseuse.

8. Circuit de commutation (100) selon l'une des revendications 5 à 7, dans lequel la première et/ou la deuxième diode (11, 12) prennent la forme d'une diode Zener.

9. Circuit de commutation (100) selon l'une des revendications précédentes, comprenant en outre un condensateur (1), dans lequel une première borne du condensateur (1) est connectée électriquement à la borne de gâchette (61) du premier FET (60) et dans lequel une seconde borne du condensateur (1) est connectée électriquement à la seconde borne de connexion (70).

10. Circuit de commutation (100) selon l'une des revendications précédentes, comprenant en outre une troisième diode (13), dans lequel la borne de commande (90) est connectée électriquement à l'anode de la troisième diode (13).

11. Système de commutation (200), comprenant au moins deux circuits de commutation (100) qui sont configurés selon la revendication 10 respectivement, dans lequel la cathode de la troisième diode (13) de l'un des au moins deux circuits de commutation (100) est connectée électriquement à la borne de commande (90) de l'autre des au moins deux circuits de commutation (100).
